(19) Europäisches Patentamt / European Patent Office / Office européen des brevets

(11) **EP 4 782 858 A1**

(12) **EUROPEAN PATENT APPLICATION**
published in accordance with Art. 153(4) EPC

(43) Date of publication:
**29.07.2026 Bulletin 2026/31**

(21) Application number: **24887480.2**

(22) Date of filing: **26.07.2024**

(51) International Patent Classification (IPC):
**G01R 31/52** (2020.01)     **G01R 31/00** (2006.01)

(52) Cooperative Patent Classification (CPC):
Y02B 40/00

(86) International application number:
**PCT/CN2024/107726**

(87) International publication number:
**WO 2025/097858 (15.05.2025 Gazette 2025/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.11.2023 CN 202311471358**

(71) Applicant: **Guangdong Midea Kitchen Appliances Manufacturing Co., Ltd.**
**Foshan, Guangdong 528311 (CN)**

(72) Inventors:
• **TAKASHIGE, Yutaka**
  **Foshan, Guangdong 528311 (CN)**

• **CHENG, Yan**
  **Foshan, Guangdong 528311 (CN)**
• **LI, Qinghai**
  **Foshan, Guangdong 528311 (CN)**
• **LIU, Xinghua**
  **Foshan, Guangdong 528311 (CN)**
• **XU, Xiaoping**
  **Foshan, Guangdong 528311 (CN)**
• **CHEN, Fei**
  **Foshan, Guangdong 528311 (CN)**

(74) Representative: **Ran, Handong et al**
**Maucher Jenkins**
**Seventh Floor Offices**
**Artillery House**
**11-19 Artillery Row**
**London SW1P 1RT (GB)**

(54) **ANOMALY DETECTION METHOD AND APPARATUS, READABLE STORAGE MEDIUM AND COOKING APPLIANCE**

(57)     Provided in the present application are an anomaly detection method and apparatus, a readable storage medium and a cooking appliance. The anomaly detection method comprises: acquiring an input voltage of a rectifier circuit; when the input voltage of the rectifier circuit is less than or equal to a first voltage value, collecting a voltage waveform of a first end of a switching device, the voltage waveform being a waveform drawn on the basis of a voltage value of the first end of the switching device when no current flows through the switching device; and, according to a comparison result of a duration corresponding to the voltage waveform and a preset duration, determining an anomaly detection result of a cooking appliance. When a magnetron or a circuit located on the rear side of a step-up transformer is short-circuited, the present application can detect said anomaly event in a timely manner, so as to maintain the cooking appliance according to the anomaly detection result, thereby minimizing damage to the cooking appliance caused by the anomaly.

```
                    Start
                      │
                      ▼
  ┌──────────────────────────────────────────┐
  │ Acquiring an input voltage of a rectifier │ ─── 202
  │ circuit                                    │
  └──────────────────────────────────────────┘
                      │
                      ▼
  ┌──────────────────────────────────────────┐
  │ When the input voltage of the rectifier   │
  │ circuit is less than or equal to a first  │
  │ voltage value, collecting a voltage       │ ─── 204
  │ waveform of a first end of the switching  │
  │ device, the voltage waveform being a      │
  │ waveform drawn on the basis of a voltage  │
  │ value of the first end of the switching   │
  │ device when no current flows through the  │
  │ switching device                          │
  └──────────────────────────────────────────┘
                      │
                      ▼
  ┌──────────────────────────────────────────┐
  │ Determining an anomaly detection result   │
  │ of the cooking appliance according to a   │ ─── 206
  │ comparison result of a duration           │
  │ corresponding to the voltage waveform and │
  │ a preset duration                         │
  └──────────────────────────────────────────┘
                      │
                      ▼
                    End

                   FIG. 2
```

EP 4 782 858 A1

## Description

This application claims priority to Chinese Patent Application No. 202311471358.8 filed with the China National Intellectual Property Administration on November 7, 2023 and entitled "ANOMALY DETECTION METHOD AND APPARATUS, READABLE STORAGE MEDIUM AND COOKING APPLIANCE", the entire contents of which are incorporated by reference herein.

## FIELD

The present application relates to the technical field of data processing, and in particular to an anomaly detection method and apparatus, a computer-readable storage medium and a cooking appliance.

## BACKGROUND

Cooking appliances may radiate microwaves via a magnetron and use the microwaves to heat an object to be heated.

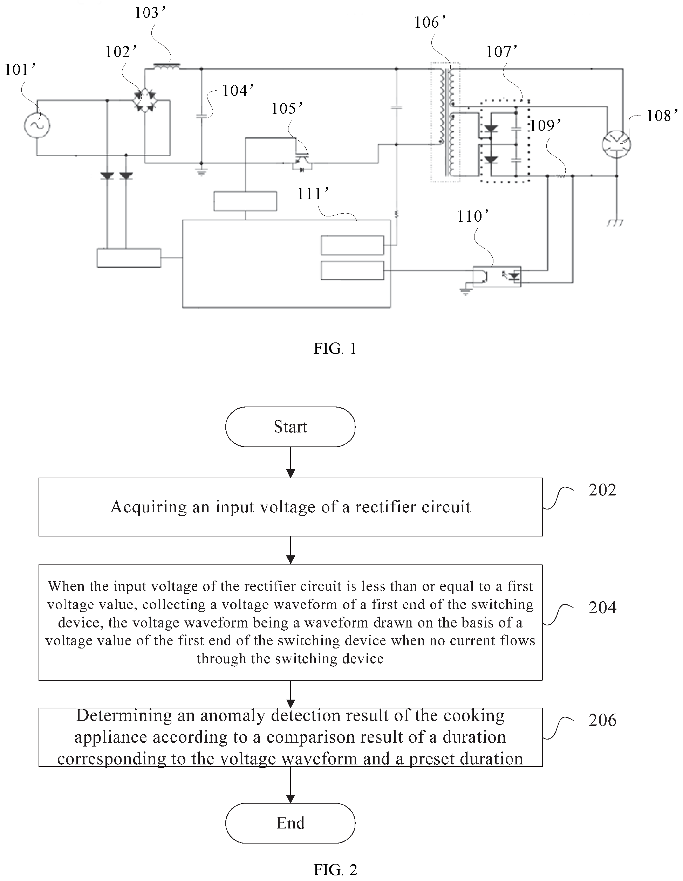

In the related art, as shown in FIG. 1, an AC (alternating current) power supply 101' supplies an alternating current to a rectifier circuit 102', which converts the alternating current into a DC (direct current) voltage. After ripples in the DC voltage are filtered out by a smoothing capacitor 103' and a coil 104', the DC voltage supplies power to the magnetron by turning on and off a switching element 105'.

During a turn-off interval, a voltage generated in a primary winding of a step-up transformer 106' resonates with a resonant capacitor to produce a voltage. A secondary-side voltage boosted by the step-up transformer passes through a rectifying and smoothing circuit 107' composed of a diode and a capacitor, thereby driving a magnetron 108' that operates at a high voltage.

If a fault such as a short circuit occurs in the magnetron 108', the short-circuit current will cause a current flowing through a detection resistor 109' to increase beyond a normal value, thereby raising the voltages across the detection resistor. This causes the current to flow through the diode section of an optocoupler 110', and the output signal of the output transistor of the optocoupler 110' is input to a secondary-side current detector. An abnormal signal is then sent to a control circuit 111' to implement a protection operation. However, the current is connected to a secondary side via the detection resistor 109', while the control circuit 111' is connected to a primary side. Therefore, signal transmission via insulation is required, and an optocoupler is further needed to use an insulated component. This increases the number of components including peripheral components, leading to an increase in cost .

In addition, high-voltage components are provided in the magnetron, and rectifying and smoothing components such as diodes and capacitors are further provided in the high-voltage rectifier circuit. However, if a malfunction such as a short circuit occurs due to an abnormality in these components, the short-circuit current caused by the component malfunction does not flow through the detection resistor, so detection may not be possible in some cases.

## SUMMARY

The present application aims to solve at least one of the technical problems in the prior art or related art.

Thus, a first aspect of the present application is to provide an anomaly detection method.

A second aspect of the present application is to provide an anomaly detection apparatus.

A third aspect of the present application is to provide another anomaly detection apparatus.

A fourth aspect of the present application is to provide a computer-readable storage medium.

A fifth aspect of the present application is to provide a cooking appliance.

A sixth aspect of the present application is to provide another cooking appliance.

In view of this, according to the first aspect of the present application, the present application provides an anomaly detection method for a cooking appliance, the cooking appliance comprises a rectifier circuit, a variable frequency circuit and a magnetron, the variable frequency circuit comprises a switching device and a step-up transformer, and a first end of the switching device is connected to a primary coil of the step-up transformer. The anomaly detection method comprises: acquiring an input voltage of the rectifier circuit; when the input voltage of the rectifier circuit is less than or equal to a first voltage value, collecting a voltage waveform of the first end of the switching device, the voltage waveform being a waveform drawn on the basis of a voltage value of the first end of the switching device when no current flows through the switching device; determining an anomaly detection result of the cooking appliance according to a comparison result between a duration corresponding to the voltage waveform and a preset duration.

In addition, the anomaly detection method provided in the present application further comprise the following additional technical features.

In some embodiments, determining an anomaly detection result of the cooking appliance according to a comparison result between a duration corresponding to the voltage waveform and a preset duration comprises: if the duration corresponding to the voltage waveform is less than the preset duration, the cooking appliance is abnormal; if the duration corresponding to the voltage waveform is greater than or equal to the preset duration, the cooking appliance is normal.

In some embodiments, wherein, the duration corresponding to the voltage waveform corresponds to a first width value, and the preset duration corresponds to a second width value. Determining an anomaly detection result of the cooking appliance according to a comparison result between a duration corresponding to the voltage waveform and a preset duration comprises: if the first width value is less than the second width value, the cooking appliance is abnormal; if the first width value is greater than or equal to the second width value, the cooking appliance is normal.

In some embodiments, wherein, the anomaly detection method further comprises controlling an operating state of the switching device according to an anomaly detection result of the cooking appliance.

In some embodiments, wherein, controlling an operating state of the switching device according to an anomaly detection result of the cooking appliance comprises: controlling the switching device to stop operating when the cooking appliance is abnormal; controlling the switching device to continue operating when the cooking appliance is normal.

In some embodiments, wherein, the anomaly detection method further comprises: controlling the switching device to stop operating when the voltage value at the first end of the switching device is greater than or equal to a second voltage value; wherein the first voltage value is less than the second voltage value.

According to the second aspect of the present application, the present application provides an anomaly detection apparatus for a cooking appliance, the cooking appliance comprises a rectifier circuit, a variable frequency circuit and a magnetron, the variable frequency circuit comprises a switching device and a step-up transformer, and a first end of the switching device is connected to a primary coil of the step-up transformer. The anomaly detection apparatus comprises: an acquiring unit configured to acquire an input voltage of the rectifier circuit; a collecting unit configured to collect a voltage waveform of the first end of the switching device when the input voltage of the rectifier circuit is less than or equal to a first voltage value; a determining unit configured to determine an anomaly detection result of the cooking appliance according to a comparison result between a duration corresponding to the voltage waveform and a preset duration.

In addition, the anomaly detection apparatus provided in the present application can further comprise following additional technical features.

In some embodiments, wherein, the determining unit is configured to determine that the cooking appliance is abnormal when the duration corresponding to the voltage waveform is less than the preset duration, and that the cooking appliance is normal when the duration corresponding to the voltage waveform is greater than or equal to the preset duration.

In some embodiments, wherein, the duration corresponding to the voltage waveform corresponds to a first width value, and the preset duration corresponds to a second width value. The determining unit is configured to determine that the cooking appliance is abnormal when the first width value is less than the second width value, and that the cooking appliance is normal when the first width value is greater than or equal to the second width value.

In some embodiments, wherein, the determining unit is further configured to control an operating state of a switching device according to an anomaly detection result of the cooking appliance.

In some embodiments, wherein, the determining unit is configured to control the switching device to stop operating when the cooking appliance is abnormal, and controlling the switching device to continue operating when the cooking appliance is normal.

In some embodiments, wherein, the determining unit is further configured to control the switching device to stop operating when the voltage value at the first end of the switching device is greater than or equal to the second voltage value; wherein, the first voltage value is less than the second voltage value.

According to the third aspect of the present application, the present application provides an anomaly detection apparatus comprising a processor and a memory, the memory stores programs or instructions executable on the processor, and the steps of any method above are implemented when the programs or instructions are executed by the processor.

According to the fourth aspect of the present application, the present application provides a computer-readable storage medium in which programs or instructions are stored, and the steps of any method above are implemented when the programs or instructions are executed by the processor.

According to the fifth aspect of the present application, the present application provides a cooking appliance, comprising any one of the above anomaly detection apparatuses, and/or the above computer-readable storage medium.

According to the sixth aspect of the present application, the present application provides a cooking appliance, comprising: a rectifier circuit, an input end of the rectifier circuit being configured to receive an alternating current; a variable frequency circuit, an input end of the variable frequency circuit being connected to an output end of the rectifier circuit, the variable frequency circuit comprising a switching device and a step-up transformer, a first end of the switching device being connected to a primary coil of the step-up transformer; a magnetron connected to an output end of the variable frequency circuit; a voltage detection circuit connected to the input end of the rectifier circuit and configured to collect an input voltage of the rectifier circuit; and a control circuit connected to the voltage detection circuit and the first end of the switching device, and configured to perform the steps of any one of the above methods.

In addition, the cooking appliance provided in the present application further comprise the following additional technical features.

In some embodiments, wherein, the control circuit comprises a waveform detection circuit configured to collect a voltage waveform of a first end of the switching device. The cooking appliance further comprises: a first resistor connected in series between the first end of the switching device and the waveform detection circuit, a first end of the first resistor being connected to the first end of the switching device, and a second end of the first resistor being connected to the waveform detection circuit; and a second resistor, a first end of the second resistor being connected to the second end of the first resistor, and a second end of the second resistor being grounded.

In some embodiments, wherein, the control circuit comprises an overvoltage detection circuit, and the overvoltage detection circuit is connected to the second end of the first resistor and configured to detect a voltage value of the first end of the switching device.

In some embodiments, wherein, the cooking appliance further comprises a drive circuit, an input end of the drive circuit is connected to the control circuit, an output end of the drive circuit is connected to a control end of the switching device, and the drive circuit is configured to drive the switching device to act.

The additional aspects and advantages of the present application will become apparent in the following description or may be learned via practice of the present application.

**BRIEF DESCRIPTION OF THE DRAWINGS**

The above-mentioned and/or additional aspects and advantages of the present application will become apparent and easily understandable from the description of the embodiments in combination with the following accompanying drawings, wherein:

FIG. 1 shows a topological schematic view of a cooking appliance in a related embodiment;

FIG. 2 shows a first schematic view of the flow of an anomaly detection method in an embodiment of the present application;

FIG. 3 shows a topological schematic view of a cooking appliance in an embodiment of the present application;

FIG. 4 shows a schematic view of the voltage and current of a magnetron under a normal condition in an embodiment of the present application;

FIG. 5 shows a schematic view of the voltage and current of a magnetron under an abnormal condition in an embodiment of the present application;

FIG. 6 shows a schematic diagram of the variation of an OFF width in an embodiment of the present application;

FIG. 7 shows a second schematic view of the flow of an anomaly detection method in an embodiment of the present application;

FIG. 8 shows a schematic block diagram of an anomaly detection apparatus in an embodiment of the present application;

FIG. 9 shows a schematic block diagram of another anomaly detection apparatus in an embodiment of the present application.

Wherein, the corresponding relationships between the reference signs and the component names in FIG. 1 are as follows:

101' AC (alternating current) power supply, 102' rectifier circuit, 103' smoothing capacitor, 104' coil, 105' switching device, 106' step-up transformer, 107' rectifying and smoothing circuit, 108' magnetron, 109' detection resistor, 110' photocoupler, 111' control circuit.

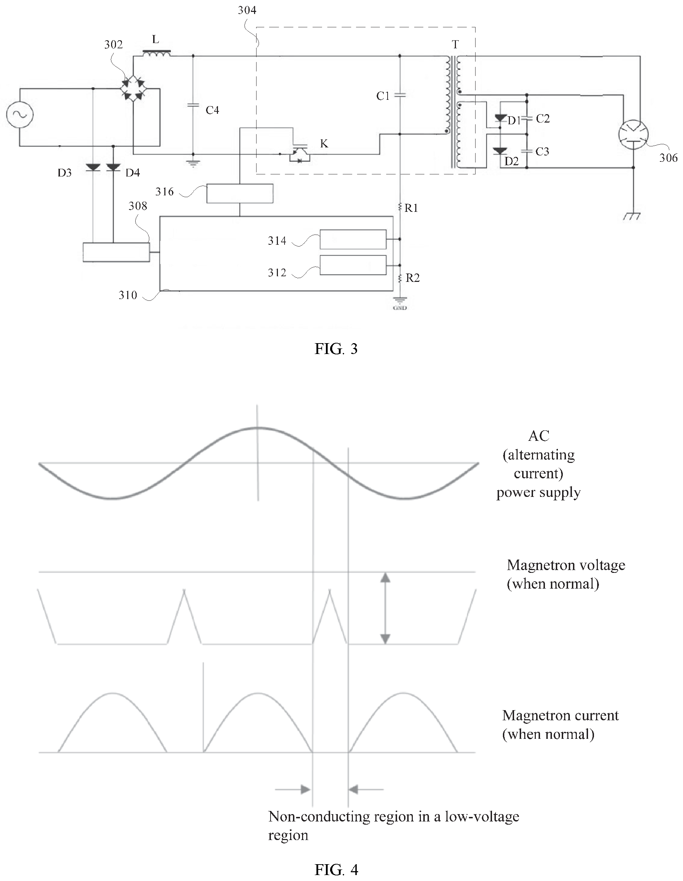

Wherein, the corresponding relationships between the reference signs and the component names in FIG. 3 are as follows:

302 rectifier circuit, 304 variable frequency circuit, 306 magnetron, 308 voltage detection circuit, 310 control circuit, 312 waveform detection circuit, 314 overvoltage detection circuit, 316 drive circuit, C1 resonant capacitor, K switching device, T step-up transformer, R1 first resistor, R2 second resistor, D1 first diode, D2 second diode, D3 third diode, D4 fourth diode, C2 first capacitor, C3 second capacitor, C4 smoothing capacitor, L coil.

**DETAILED DESCRIPTION OF THE APPLICATION**

To more clearly understand the above aspects, features and advantages of the present application, the present application will be further detailed hereinafter with reference to the accompanying drawings and embodiments. It should be indicated that in the case of no conflict, the embodiments and the features in the embodiments of the present application can be combined with each other.

Many details are illustrated in the following description for the convenience of a thorough understanding to the present application, but the embodiments of the present application can further be implemented using other embodiments other than these described herein. Therefore, the protection scope of the present application is not limited to the embodiments disclosed in the following text.

In an embodiment of the present application, as shown in FIG. 2 and FIG. 3, an anomaly detection method for a cooking appliance is provided, the cooking appliance comprises a rectifier circuit 302, a variable frequency circuit 304 and a magnetron 306, the variable frequency circuit 304 comprises a switching device K and a step-up transformer T, and a first end of the switching device K is connected to a primary coil of the step-up transformer T, as shown in FIG. 2, the anomaly detection method comprises:

Step 202, acquiring an input voltage of the rectifier circuit;

Step 204, when the input voltage of the rectifier circuit is less than or equal to a first voltage value, collecting a voltage waveform of the first end of the switching device, the voltage waveform being a waveform drawn on the basis of a voltage value of the first end of the switching device when no current flows through the switching device;

Step 206, determining an anomaly detection result of the cooking appliance according to a comparison result between a duration corresponding to the voltage waveform and a preset duration.

An embodiment of the present application provides an anomaly detection method. By executing the above anomaly detection method, an anomaly event can be detected in a timely manner when a short circuit occurs in the magnetron 306 or a circuit located at the rear side of the step-up transformer T, to maintain the cooking appliance according to the anomaly detection result, and minimize damage to the cooking appliance caused by the above anomaly.

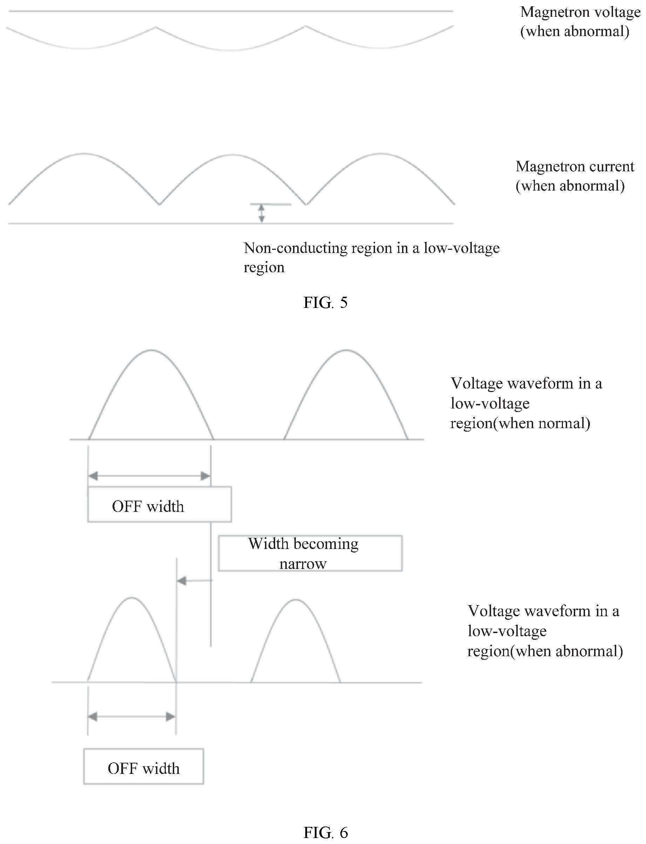

The above embodiment of the present application is implemented based on the following principle. As shown in FIG. 4, FIG. 5 and FIG. 6, due to the constant voltage characteristic of a high voltage, the working of the magnetron 306 has a non-conducting region in a low-voltage region of the AC power supply where the magnetron 306 does not work. In this region, no current flows in a secondary side winding of the step-up transformer T. However, when the magnetron 306 is short-circuited, the non-conducting region disappears, so current further flows in the secondary side winding of the step-up transformer T even in the low-voltage region of the AC voltage.

Thus, by collecting the voltage waveform of the first end of the switching device K, the state of the above-mentioned non-conducting region is evaluated based on the comparison result between the duration corresponding to the voltage waveform and the preset duration, thereby detecting whether the magnetron 306 is short-circuited.

In addition, anomaly is detected by means of the voltage waveform of the first end of the switching device K. When a high-voltage component connected to the secondary side of the step-up transformer T is short-circuited due to an anomaly or other causes, a short-circuit current flows in the secondary winding of the step-up transformer T, whereas no current flows under normal conditions, and thus the anomaly of the magnetron 306 can be detected when current flow is detected. In this way, it is possible to detect not only a short circuit of the magnetron 306, but further an anomaly of a circuit component connected to the secondary winding side of the step-up transformer T, thereby improving safety and other quality-related performance.

Wherein, an OFF width is determined by the resonant voltage between the inductance of the primary winding of the step-up transformer T and the capacitance of the resonant capacitor C1, and the general formula is as follows:

$$f = 1 \, / \, 2\pi\sqrt{(LC)} \, ;$$

Wherein, $f$ represents the OFF width, $L$ represents the inductance of the primary winding of the step-up transformer T, and $C$ represents the capacitance of the resonant capacitor C1.

The resonant capacitor C1 is usually a thin film capacitor, so its capacitance variation is small. However, the inductance of the primary winding of the step-up transformer T decreases due to the current in the secondary winding, because the primary and secondary windings are coupled in terms of transformer characteristics. As a characteristic of a transformer, it has a coupling coefficient characteristic, the step-up transformer T used in a high-frequency heating device is usually set with Ks = 0.6 to 0.8. The general formula for the coupling coefficient is as follows:

$$K_S = \sqrt{(1 - Ls \, / \, Lo)} \, ;$$

$K_S$ is the coupling coefficient, $Ls$ is the inductance when the secondary is short-circuited, and $Lo$ is the inductance when the secondary is open-circuited.

For example, if this formula is used to calculate $Ls$ with a coupling coefficient $K_S$ = 0.7 and Lo = 40 $\mu$H, then Ls = 20.4 $\mu$H. This means that when the secondary winding of the step-up transformer T is open and no current flows, the primary inductance is 40 $\mu$H, whereas when the secondary current increases and a short circuit occurs, the inductance decreases to 20.4 $\mu$H.

Notably, the embodiments of the present application perform detection without using insulating elements such as an optocoupler, which can reduce the manufacturing cost of the cooking appliance.

In some embodiments, wherein, the first end of the switching device K is the collector of the switching device K.

In some embodiments, wherein, the first voltage value may be determined according to the working parameters of the magnetron 306, and the specific values thereof will not be repeated here.

In some embodiments, wherein, the duration corresponding to the voltage waveform of the first end of the switching device K may be recorded as the preset duration when the cooking appliance is in a normal state and the input voltage of the rectifier circuit 302 is less than or equal to the first voltage value.

In some embodiments, wherein, the voltage waveform has time as its abscissa and the voltage value of the first end of the switching device K as its ordinate. Accordingly, the duration corresponding to the voltage waveform can be understood as an accumulated duration of a measured voltage value when no current flows through the switching device K.

In some embodiments, wherein, determining an anomaly detection result of the cooking appliance according to a comparison result between a duration corresponding to the voltage waveform and a preset duration comprises: if the duration corresponding to the voltage waveform is less than the preset duration, the cooking appliance is abnormal; if the duration corresponding to the voltage waveform is greater than or equal to the preset duration, the cooking appliance is normal.

In this embodiment, wherein, based on the above principle, it can be seen that when a short circuit occurs in the magnetron 306, the switching device K will further be conducted in the non-conducting region. Based on this, it is obvious that the voltage waveform of the first end of the switching device K without current flowing through it will become narrow.

Based on this, when the duration corresponding to the voltage waveform is less than the preset duration, the cooking appliance is determined to be abnormal, for example, a short circuit occurs in the magnetron 306 or a component located on the secondary side of the step-up transformer T. On the contrary, when the duration corresponding to the voltage waveform is greater than or equal to the preset duration, it is determined that the above short circuit does not occur.

In some embodiments, wherein, the duration corresponding to the voltage waveform corresponds to a first width value, and the preset duration corresponds to a second width value. Determining an anomaly detection result of the cooking appliance according to a comparison result between a duration corresponding to the voltage waveform and a preset duration comprises: if the first width value is less than the second width value, the cooking appliance is abnormal; if the first width value is greater than or equal to the second width value, the cooking appliance is normal.

In this embodiment, the determination of whether the cooking appliance is abnormal is implemented from another perspective.

In this embodiment, whether the cooking appliance is abnormal can be determined based on the width value of the voltage waveform. In this process, it can meet the application requirements in different scenarios, thereby enabling a relatively intuitive judgment of whether the cooking appliance is abnormal.

In some embodiments, wherein, the anomaly detection method further comprises controlling an operating state of the switching device K according to an anomaly detection result of the cooking appliance.

In this embodiment, the operating state of the switching device K can be controlled according to the anomaly detection result of the cooking appliance. In this process, the cooking appliance can be further controlled, and when an anomaly of the cooking appliance is detected, further protection of the cooking appliance is realized via the switching device K in a timely manner, and the probability of failure of the cooking appliance is reduced.

In some embodiments, wherein, controlling an operating state of the switching device K according to an anomaly detection result of the cooking appliance comprises: controlling the switching device K to stop operating when the cooking appliance is abnormal; controlling the switching device K to continue operating when the cooking appliance is normal.

In this embodiment, when an anomaly of the cooking appliance is detected, the switching device K is controlled to stop operating, and the cooking appliance stops operating when the switching device K stops operating, thereby further protecting the cooking appliance.

Meanwhile, when no anomaly of the cooking appliance is detected, by controlling the switching device K to continue operating, the impact of the above anomaly detection on the operation of the cooking appliance is reduced, thereby ensuring stable operation of the cooking appliance.

In some embodiments, wherein, the cooking appliance is normal, which can be understood as no anomaly of the cooking appliance detected.

In some embodiments, wherein, the anomaly detection method further comprises: controlling the switching device K to stop operating when the voltage value of the first end of the switching device K is greater than or equal to a second voltage value; wherein the first voltage value is less than the second voltage value.

In this embodiment, the voltage value of the first end of the switching device K is compared with the second voltage value, to implement overvoltage protection according to the comparison result. In this process, when overvoltage occurs, the switching device K is controlled to stop operating to timely interrupt the operation of the cooking appliance, thereby reducing failures of the cooking appliance caused by overvoltage and reducing the situation of impacting on the stable operation of the cooking appliance.

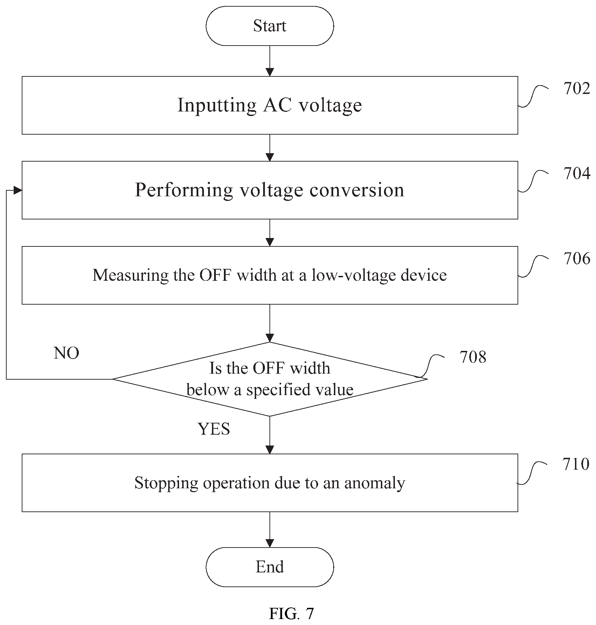

In some embodiments, as shown in FIG. 7, the anomaly detection method comprises:

    Step 702: inputting AC voltage;

    Step 704: performing voltage conversion;

    Step 706: measuring the OFF width with a low-voltage device;

    Step 708: if the OFF width is less than a specified value and if a judgment result is YES, executing Step 710, and executing Step 704 if the judgment result is NO;

    Step 710: stopping operation due to an anomaly.

In this embodiment, the OFF width refers to the first width value in the present application, and the specified value refers to the second width value in the present application.

In this embodiment, the short circuit of the magnetron 306 is determined by comparing the OFF width with the specified value.

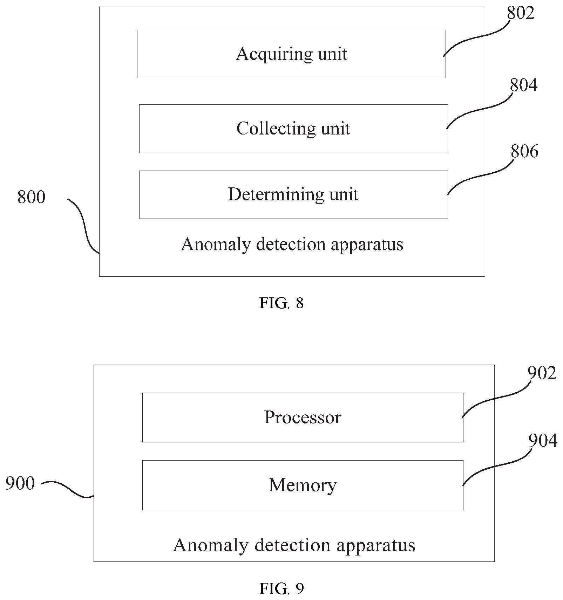

In an embodiment of the present application, as shown in FIG. 8, the present application provides an anomaly detection apparatus 800 for a cooking appliance, the cooking appliance comprises a rectifier circuit 302, a variable frequency circuit 304 and a magnetron 306, the variable frequency circuit 304 comprises a switching device K and a step-up transformer T, and a first end of the switching device K is connected to a primary coil of the step-up transformer T. The anomaly detection apparatus comprises: an acquiring unit 802 configured to acquire an input voltage of the rectifier circuit 302; a collecting unit 804 configured to collect a voltage waveform of the first end of the switching device when the input voltage of the rectifier circuit 302 is less than or equal to a first voltage value; a determining unit 806 configured to determine an anomaly detection result of the cooking appliance according to a comparison result between a duration corresponding to the voltage waveform and a preset duration.

An embodiment of the present application provides an anomaly detection apparatus 800, which can timely detect the above anomaly event when a short circuit occurs in the magnetron 306 or a circuit located at the rear side of the step-up transformer T, to maintain the cooking appliance according to the anomaly detection result, and minimize damage to the cooking appliance caused by the above anomaly.

The above embodiment of the present application is implemented based on the following principle. Wherein, due to the constant voltage characteristic of a high voltage, the working of the magnetron 306 has a non-conducting region in a low-voltage region of the AC power supply where the magnetron 306 does not work. In this region, no current flows in a secondary side winding of the step-up transformer T. However, when the magnetron 306 is short-circuited, the non-conducting region disappears, so current further flows in the secondary side winding of the step-up transformer T even in the low-voltage region of the AC voltage.

Thus, by collecting the voltage waveform of the first end of the switching device K, the state of the above-mentioned non-conducting region is evaluated based on the comparison result between the duration corresponding to the voltage waveform and the preset duration, thereby detecting whether the magnetron 306 is short-circuited.

In addition, anomaly is detected by means of the voltage waveform of the first end of the switching device K. When a high-voltage component connected to the secondary side of the step-up transformer T is short-circuited due to an anomaly or other causes, a short-circuit current flows in the secondary winding of the step-up transformer T, whereas no current flows under normal conditions, and thus the anomaly of the magnetron 306 can be detected when current flow is detected. In this way, it is possible to detect not only a short circuit of the magnetron 306, but further an anomaly of a circuit component connected to the secondary winding side of the step-up transformer T, thereby improving safety and other quality-related performance.

Notably, the embodiments of the present application enable detection without using insulating elements such as an optocoupler, which can reduce the manufacturing cost of the cooking appliance.

In some embodiments, the first end of the switching device K is the collector of the switching device K.

In some embodiments, wherein, the first voltage value may be determined according to the working parameters of the magnetron 306, and the specific values thereof will not be repeated here.

In some embodiments, the duration corresponding to the voltage waveform of the first end of the switching device K may be recorded as the preset duration when the cooking appliance is in a normal state and the input voltage of the rectifier circuit 302 is less than or equal to the first voltage value.

In some embodiments, the voltage waveform has time as its abscissa and the voltage value of the first end of the switching device K as its ordinate. Accordingly, the duration corresponding to the voltage waveform can be understood as an accumulated duration of a measured voltage value when no current flows through the switching device K.

In some embodiments, wherein, the determining unit 806 is configured to determine that the cooking appliance is abnormal when the duration corresponding to the voltage waveform is less than the preset duration, and that the cooking appliance is normal when the duration corresponding to the voltage waveform is greater than or equal to the preset duration.

In this embodiment, based on the above principle, it can be seen that when a short circuit occurs in the magnetron 306, the switching device K will further be conducted in the non-conducting region. Based on this, it is obvious that the voltage waveform of the first end of the switching device K without current flowing through it will become narrow.

Based on this, when the duration corresponding to the voltage waveform is less than the preset duration, the cooking appliance is determined to be abnormal, for example, a short circuit occurs in the magnetron 306 or a component located on the secondary side of the step-up transformer T. On the contrary, when the duration corresponding to the voltage waveform is greater than or equal to the preset duration, it is determined that the above short circuit does not occur.

In some embodiments, the duration corresponding to the voltage waveform corresponds to a first width value, and the preset duration corresponds to a second width value. The determining unit 806 is configured to determine that the cooking appliance is abnormal when the first width value is less than the second width value, and that the cooking appliance is normal when the first width value is greater than or equal to the second width value.

In this embodiment, the determination of whether the cooking appliance is abnormal is realized from another perspective.

In this embodiment, whether the cooking appliance is abnormal can be determined based on the width value of the voltage waveform. In this process, it can meet the application requirements in different scenarios, thereby enabling a relatively intuitive judgment of whether the cooking appliance is abnormal.

In some embodiments, the determining unit 806 is further configured to control an operating state of a switching device K according to an anomaly detection result of the cooking appliance.

In this embodiment, the operating state of the switching device K can be controlled according to the anomaly detection result of the cooking appliance. In this process, the cooking appliance can be further controlled, and when an anomaly of the cooking appliance is detected, further protection of the cooking appliance is realized via the switching device K in a timely manner, and the probability of failure of the cooking appliance is reduced.

In some embodiments, the determining unit 806 is configured to control the switching device K to stop operating when the cooking appliance is abnormal, and to control the switching device K to continue operating when the cooking appliance is normal.

In this embodiment, when an anomaly of the cooking appliance is detected, the switching device K is controlled to stop operating, and the cooking appliance stops operating when the switching device K stops operating, thereby further protecting the cooking appliance.

Meanwhile, when no anomaly of the cooking appliance is detected, by controlling the switching device K to continue operating, the impact of the above anomaly detection on the operation of the cooking appliance is reduced, thereby ensuring stable operation of the cooking appliance.

In some embodiments, the cooking appliance is normal, which can be understood as no anomaly of the cooking appliance being detected.

In some embodiments, the determining unit 806 is further configured to control the switching device K to stop operating when the voltage value at the first end of the switching device K is greater than or equal to the second voltage value; wherein, the first voltage value is less than the second voltage value.

In this embodiment, the voltage value of the first end of the switching device K is compared with the second voltage value, to implement overvoltage protection according to the comparison result. In this process, when overvoltage occurs, the switching device K is controlled to stop operating to timely interrupt the operation of the cooking appliance, thereby reducing failures of the cooking appliance caused by overvoltage and reducing impact on the stable operation of the cooking appliance.

In an embodiment of the present application, as shown in FIG. 9, the present application provides an anomaly detection apparatus 900 comprising a processor 902 and a memory 904, the memory 904 stores programs or instructions executable by the processor 902, and the steps of any method above are implemented when the programs or instructions are executed by the processor 902.

The methods may be implemented in various ways according to applications of specific features and/or examples. For example, the methods may be implemented by a combination of hardware, firmware, and/or software. For instance, in a hardware implementation, the processor may be implemented in one or more Application-Specific Integrated Circuits (ASICs), Digital Signal Processors (DSPs), Digital Signal Processing Devices (DSPDs), Programmable Logic Devices (PLDs), Field-Programmable Gate Arrays (FPGAs), controllers, microcontrollers, microprocessors, electronic apparatuses, and other device units for executing the above functions, and/or combinations thereof.

In an embodiment of the present application, the present application provides a computer-readable storage medium in which programs or instructions are stored, and the steps of any method above are implemented when the programs or instructions are executed by the processor.

A computer-readable storage medium may be a tangible device that can retain and store instructions for use by an instruction execution device. The computer-readable storage medium may be, but is not limited to, an electronic storage device, a magnetic storage device, an optical storage device, an electromagnetic storage device, a semiconductor storage device, or any suitable combination of the foregoing. A non-exhaustive list of more specific examples of the computer-readable storage medium comprises: a portable computer floppy disk, a hard disk, a random-access memory (RAM), a read-only memory (ROM), an erasable programmable read-only memory (EPROM or Flash memory), a static random-access memory (SRAM), a portable compact disc read-only memory (CD-ROM), a digital versatile disc (DVD), a memory card, a floppy disk, an encoding mechanical device (such as a punched card or a groove with raised structures having instructions recorded thereon), and any suitable combination of the foregoing. A computer-readable storage medium, as used herein, should not be construed as a transitory signal itself, such as radio waves or other freely propagating electromagnetic waves, electromagnetic waves propagating through a waveguide or other transmission medium, or electrical signals transmitted through electrical wires.

In an embodiment of the present application, the present application provides a cooking appliance, comprising any one of the above anomaly detection apparatuses, and/or the above computer-readable storage medium.

In an embodiment of the present application, as shown in FIG. 3, the present application provides a cooking appliance, comprising: a rectifier circuit 302, an input end of the rectifier circuit 302 being configured to receive an alternating current; a variable frequency circuit 304, an input end of the variable frequency circuit being connected to an output end of the rectifier circuit 302, the variable frequency circuit 304 comprising a switching device K and a step-up transformer T, a first end of the switching device K being connected to a primary coil of the step-up transformer T; a magnetron 306 connected to an output end of the variable frequency circuit; a voltage detection circuit 308 connected to the input end of the rectifier circuit 302 and configured to collect an input voltage of the rectifier circuit 302;and a control circuit 310 connected to the voltage detection circuit 308 and the first end of the switching device K, and configured to perform the steps of any one of the above methods.

In this embodiment, the above anomaly event can be detected timely when a short circuit occurs in the magnetron 306 or a circuit located at the rear side of the step-up transformer T, to maintain the cooking appliance according to the anomaly detection result, and minimize damage to the cooking appliance caused by the above anomaly.

The above embodiment of the present application is implemented based on the following principle. Due to the constant voltage characteristic of a high voltage, the working of the magnetron 306 has a non-conducting region in a low-voltage region of the AC power supply where the magnetron 306 does not work. In this region, no current flows in a secondary side winding of the step-up transformer T. However, when the magnetron 306 is short-circuited, the non-conducting region disappears, so current further flows in the secondary side winding of the step-up transformer T even in the low-voltage region of the AC voltage.

Thus, by collecting the voltage waveform of the first end of the switching device K, the state of the above-mentioned non-conducting region is evaluated based on the comparison result between the duration corresponding to the voltage waveform and the preset duration, thereby detecting whether the magnetron 306 is short-circuited.

In addition, anomaly is detected by means of the voltage waveform of the first end of the switching device K. When a high-voltage component connected to the secondary side of the step-up transformer T is short-circuited due to an anomaly or other causes, a short-circuit current flows in the secondary winding of the step-up transformer T, whereas no current flows under normal conditions, and thus the anomaly of the magnetron 306 can be detected when current flow is detected. In this way, it is possible to detect not only a short circuit of the magnetron 306, but further an anomaly of a circuit component connected to the secondary winding side of the step-up transformer T, thereby improving safety and other quality-related performance.

Notably, the embodiments of the present application enable detection without using insulating elements such as an optocoupler, which can reduce the manufacturing cost of the cooking appliance.

In some embodiments, the first end of the switching device K is the collector of the switching device K.

In some embodiments, the first voltage value may be determined according to the working parameters of the magnetron 306, and the specific values thereof will not be repeated here.

In some embodiments, the duration corresponding to the voltage waveform of the first end of the switching device K may be recorded as the preset duration when the cooking appliance is in a normal state and the input voltage of the rectifier circuit 302 is less than or equal to the first voltage value.

In some embodiments, wherein, the voltage waveform has time as its abscissa and the voltage value of the first end of the switching device K as its ordinate. Accordingly, the duration corresponding to the voltage waveform can be understood as an accumulated duration of a measured voltage value when no current flows through the switching device K.

In addition, the cooking appliance provided in the present application can further comprise the following additional technical features.

In some embodiments, the control circuit 310comprises a waveform detection circuit 312 configured to collect a voltage waveform of a first end of the switching device K. The cooking appliance further comprises: a first resistor R1 connected in series between the first end of the switching device K and the waveform detection circuit 312, a first end of the first resistor R1 being connected to the first end of the switching device K, and a second end of the first resistor R1 being connected to the waveform detection circuit 312; and a second resistor R2, a first end of the second resistor R2 being connected to the second end of the first resistor R1, and a second end of the second resistor R2 being grounded.

In this embodiment, the first resistor R1 and the second resistor R2 are provided to form a loop between the first end of the switching device K and the ground by means of the first resistor R1 and the second resistor R2, thereby generating a voltage division at the first resistor R1 and the second resistor R2. In this process, the voltage value of the second end of the first resistor R1 changes synchronously with the voltage value of the first end of the switching device K. Therefore, when the second end of the first resistor R1 is connected to the waveform detection circuit 312, the voltage fluctuation of the first end of the switching device K can be measured.

In some embodiments, the resistance values of the first resistor R1 and the second resistor R2 may be set according to actual application requirements, and the specific values will not be repeated here.

In some embodiments, the control circuit 310 is a chip. Based on this, it can be understood that the waveform detection circuit 312 is a module integrated in the chip.

In some embodiments, the control circuit 310comprises an overvoltage detection circuit 314, and the overvoltage detection circuit 314 is connected to the second end of the first resistor R1 and configured to detect a voltage value of the first end of the switching device K.

In this embodiment, an overvoltage detection circuit 314 is provided to implement overvoltage detection, thereby protecting the cooking appliance.

In some embodiments, the cooking appliance further comprises a drive circuit 316, an input end of the drive circuit 316 is connected to the control circuit 310, an output end of the drive circuit 316is connected to a control end of the switching device K, and the drive circuit 316 is configured to drive the switching device K to act.

In this embodiment, a drive circuit 316 is provided to drive the switching device K. In this process, this overcomes the issue that the control circuit 310 has insufficient drive capability and thus the control over the switching device K cannot be achieved directly and effectively.

By providing the drive circuit 316, the driving capability of the control circuit 310 can be improved, thereby realizing drive control of the switching device K.

In some embodiments, variable frequency circuit 304 further comprises: a resonant capacitor C1. A first end of the resonant capacitor C1 is connected to a first end of a primary coil of the step-up transformer T, and a second end of the resonant capacitor C1 is connected to the first end of the switching device K.

In this embodiment, the resonant capacitor C1 is provided and the resonant capacitor C1 resonates with the primary coil, thereby supplying power to the magnetron 306.

Wherein, the first end of the first secondary coil of the step-up transformer T is connected to the first end of the magnetron 306, and the second end of the first secondary coil of the step-up transformer T is connected to the second end of the magnetron 306. The ground end of the magnetron 306 is grounded.

In some embodiments, the variable frequency circuit 304 further comprises a voltage doubler circuit. A first input end of the voltage doubler circuit is connected to a first end of a second secondary coil of the step-up transformer T, and a second input end of the voltage doubler circuit is connected to a second end of the second secondary coil of the step-up transformer T. A first output end of the voltage doubler circuit is connected to a second end of the magnetron 306, and a second output end of the voltage doubler circuit is connected to the ground end of the magnetron 306.

In some embodiments, the voltage doubler circuit comprises: a first diode D1, an anode of the first diode D1 serves as the first output end of the voltage doubler circuit, and a cathode of the first diode D1 is connected to the first end of the second secondary coil of the step-up transformer T; a second diode D2, an anode of the second diode D2 is connected to the cathode of the first diode D1, and a cathode of the second diode D2 serves as the second output end of the voltage doubler circuit; a first capacitor C2, a first end of the first capacitor C2 is connected to the anode of the first diode D1, and a second end of the first capacitor C2 is connected to the second end of the second secondary coil of the step-up transformer T; a second capacitor C3, a first end of the second capacitor C3 is connected to the second end of the first capacitor C2, and a second end of the second capacitor C3 is connected to the cathode of the second diode D2.

In some embodiments, the variable frequency circuit 304 further comprises a smoothing capacitor C4 and a coil L, wherein a first end of the smoothing capacitor C4 is connected to a first end of a primary coil, and a second end of the smoothing capacitor C4 is connected to the second end of the switching device K; the coil L is disposed between a first output end of the rectifier circuit 302 and a first end of the smoothing capacitor C4.

In this embodiment, the smoothing capacitor C4 and the coil L are provided to supply a stable DC (direct current) voltage to the step-up transformer T, thereby improving the stability of the cooking appliance.

In some embodiments, wherein, the voltage detection circuit 308 is connected to the input end of the rectifier circuit 302 via a third diode D3 and a fourth diode D4.

Wherein, a first input end of the rectifier circuit 302 is connected to an anode of the third diode D3, and a second input end of the rectifier circuit 302 is connected to an anode of the fourth diode D4. A cathode of the third diode D3 is connected to a cathode of the fourth diode D4 and the voltage detection circuit 308.

In this embodiment, the above arrangement ensures the stability of the detection results of the voltage detection circuit 308.

In one embodiment, the cooking appliance is a microwave oven, a microwave-steam-roast all-in-one machine, or a food heating device using a magnetron for heating.

The features described by the terms "first" and "second" in the description and claims of the present application may explicitly or implicitly comprise one or more of such features. In the written description of the present application, unless stated otherwise, "a plurality of" means two or more. In addition, "and/or" in the description and claims indicates at least one of the associated objects, and the character "/" generally indicates an "or" relationship between the associated objects before and after it.

In claims, description and accompanying drawings of the present application, the term of "a plurality of"

**EP 4 782 858 A1**

indicates two or more than two, unless otherwise explicitly defined. The orientation or positional relationships indicated by the terms "upper", "lower", etc. are based on the orientation or positional relationships shown in the accompanying drawings. They are only for the convenience of describing the present application and simplifying the description process, rather than indicating or implying that the indicated device or element must have a specific orientation, be constructed and operated in a specific orientation. Therefore, such descriptions shall not be construed as limiting the present application. Terms such as "connected", "mounted", "fixed", etc. shall be understood in a broad sense. For example, "connected" may be a fixed connection, a detachable connection, or an integral connection between multiple objects; it may be a direct connection between multiple objects, or an indirect connection between multiple objects via an intermediate medium. For those of ordinary skill in the art, the specific meanings of the above terms in the present application may be understood according to actual circumstances.

In the claims, description and accompanying drawings of the present application, the description of the terms of "an embodiment", "some embodiments", "specific embodiment" and the like is intended to mean that the specific features, structures, materials or characteristics described in combination with the embodiments or examples are comprised in at least one embodiment or example of the present application. In the claims, description and accompanying drawings of the present application, the illustrative expression of the above terms may not indicate the same embodiment or example. In addition, the described specific features, structures, materials or characteristics may be combined with each other in an appropriate method in one or more of any embodiments or examples.

The above-mentioned are merely some embodiments of the present application and are not intended to limit the present application, and for one skilled in the art, various modifications and changes may be made to the present application. Any modifications, equivalent substitutions, improvements and so on should be covered within the scope of protection of the present application.

## Claims

1. An anomaly detection method for a cooking appliance, wherein:

   the cooking appliance comprises a rectifier circuit, a variable frequency circuit and a magnetron, wherein the variable frequency circuit comprises a switching device and a step-up transformer, a first end of the switching device being connected to a primary coil of the step-up transformer; and
   the anomaly detection method comprises:

   acquiring an input voltage of the rectifier circuit;
   when the input voltage of the rectifier circuit is less than or equal to a first voltage value, collecting a voltage waveform of the first end of the switching device, the voltage waveform being a waveform drawn on the basis of a voltage value of the first end of the switching device when no current flows through the switching device; and
   determining an anomaly detection result of the cooking appliance based on a comparison result between a duration corresponding to the voltage waveform and a preset duration.

2. The anomaly detection method according to claim 1, wherein the step of determining an anomaly detection result of the cooking appliance based on a comparison result between a duration corresponding to the voltage waveform and a preset duration comprises:

   if the duration corresponding to the voltage waveform is less than the preset duration, determining that the cooking appliance is abnormal; and
   if the duration corresponding to the voltage waveform is greater than or equal to the preset duration, determining that the cooking appliance is normal.

3. The anomaly detection method according to claim 1, wherein:

   the duration corresponding to the voltage waveform corresponds to a first width value, and the preset duration corresponds to a second width value; and
   the step of determining an anomaly detection result of the cooking appliance based on a comparison result between a duration corresponding to the voltage waveform and a preset duration comprises:

   if the first width value is less than the second width value, determining that the cooking appliance is abnormal; and
   if the first width value is greater than or equal to the second width value, determining that the cooking appliance is normal.

4. The anomaly detection method according to any one of claims 1 to 3, further comprising:
   controlling an operating state of the switching device based on the anomaly detection result of the cooking appliance.

5. The anomaly detection method according to claim 4, wherein the step of controlling an operating state of the switching device based on the anomaly detection result of the cooking appliance comprises:

controlling the switching device to stop operating when the cooking appliance is abnormal; and
controlling the switching device to continue operating when the cooking appliance is normal.

6. The anomaly detection method according to any one of claims 1 to 3, further comprising:

controlling the switching device to stop operating when the voltage value of the first end of the switching device is greater than or equal to a second voltage value,
wherein the first voltage value is less than the second voltage value.

7. An anomaly detection apparatus for a cooking appliance, wherein:

the cooking appliance comprises a rectifier circuit, a variable frequency circuit and a magnetron, wherein the variable frequency circuit comprises a switching device and a step-up transformer, a first end of the switching device being connected to a primary coil of the step-up transformer; and
the anomaly detection apparatus comprises:

an acquiring unit, configured to acquire an input voltage of the rectifier circuit;
a collecting unit, configured to collect a voltage waveform of the first end of the switching device when the input voltage of the rectifier circuit is less than or equal to a first voltage value; and
a determining unit, configured to determine an anomaly detection result of the cooking appliance based on a comparison result between a duration corresponding to the voltage waveform and a preset duration.

8. An anomaly detection apparatus, comprising a processor and a memory, wherein the memory has stored thereon programs or instructions executable on the processor, wherein steps of the anomaly detection method according to any one of claims 1 to 6 are implemented when the programs or instructions are executed by the processor.

9. A computer-readable storage medium, having programs or instructions stored thereon, wherein steps of the anomaly detection method according to any one of claim 1 to claim 6 are implemented when the programs or instructions are executed by the processor.

10. A cooking appliance, comprising:

the anomaly detection apparatus according to claim 7 or 8; and/or
the computer-readable storage medium according to claim 9.

11. A cooking appliance, comprising:

a rectifier circuit, an input end of the rectifier circuit being configured to receive an alternating current;
a variable frequency circuit, wherein an input end of the variable frequency circuit is connected to an output end of the rectifier circuit, and the variable frequency circuit comprises a switching device and a step-up transformer, a first end of the switching device being connected to a primary coil of the step-up transformer;
a magnetron connected to an output end of the variable frequency circuit;
a voltage detection circuit connected to the input end of the rectifier circuit and configured to collect an input voltage of the rectifier circuit; and
a control circuit connected to the voltage detection circuit and the first end of the switching device and configured to perform steps of the anomaly detection method according to any one of claim 1 to claim 6.

12. The cooking appliance according to claim 11, wherein the control circuit comprises a waveform detection circuit configured to collect a voltage waveform of the first end of the switching device, and the cooking appliance further comprises:

a first resistor connected in series between the first end of the switching device and the waveform detection circuit, a first end of the first resistor being connected to the first end of the switching device, and a second end of the first resistor being connected to the waveform detection circuit; and
a second resistor, a first end of the second resistor being connected to the second end of the first resistor, and a second end of the second resistor being grounded.

13. The cooking appliance according to claim 12, wherein the control circuit comprises an overvoltage detection circuit, wherein the overvoltage detection circuit is connected to the second end of the first resistor and is configured to detect a voltage value of the first end of the switching device.

**14.** The cooking appliance according to claim 11, further comprising:
a drive circuit, wherein an input end of the drive circuit is connected to the control circuit, an output end of the drive circuit is connected to a control end of the switching device, and the drive circuit is configured to drive the switching device to act.

EP 4 782 858 A1

FIG. 1

Start

Acquiring an input voltage of a rectifier circuit — 202

When the input voltage of the rectifier circuit is less than or equal to a first voltage value, collecting a voltage waveform of a first end of the switching device, the voltage waveform being a waveform drawn on the basis of a voltage value of the first end of the switching device when no current flows through the switching device — 204

Determining an anomaly detection result of the cooking appliance according to a comparison result of a duration corresponding to the voltage waveform and a preset duration — 206

End

FIG. 2

FIG. 3

AC
(alternating
current)
power supply

Magnetron voltage
(when normal)

Magnetron current
(when normal)

Non-conducting region in a low-voltage
region

FIG. 4

Magnetron voltage
(when abnormal)

Magnetron current
(when abnormal)

Non-conducting region in a low-voltage
region

FIG. 5

Voltage waveform in a
low-voltage
region(when normal)

OFF width

Width becoming
narrow

Voltage waveform in a
low-voltage
region(when abnormal)

OFF width

FIG. 6

Start

Inputting AC voltage — 702

Performing voltage conversion — 704

Measuring the OFF width at a low-voltage device — 706

NO

Is the OFF width below a specified value — 708

YES

Stopping operation due to an anomaly — 710

End

FIG. 7

Acquiring unit — 802

Collecting unit — 804

Determining unit — 806

800 — Anomaly detection apparatus

FIG. 8

Processor — 902

Memory — 904

900 — Anomaly detection apparatus

FIG. 9

## INTERNATIONAL SEARCH REPORT

| International application No. |
| --- |
| **PCT/CN2024/107726** |

**A. CLASSIFICATION OF SUBJECT MATTER**

G01R31/52(2020.01)i; G01R31/00(2006.01)i

According to International Patent Classification (IPC) or to both national classification and IPC

**B. FIELDS SEARCHED**

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT; GBTXT; IEEE: 美的, 高茂丰, 程艳, 黎青海, 刘兴华, 徐小平, 陈飞, 异常, 磁控管, 开关, 晶体管, 线圈, 电流, 电压, 波形, 时长, anomaly, magnetron, switch, transistor, coil, current, voltage, waveform, duration

**C. DOCUMENTS CONSIDERED TO BE RELEVANT**

| Category* | Citation of document, with indication, where appropriate, of the relevant passages | Relevant to claim No. |
| --- | --- | --- |
| PX | CN 117590276 A (GUANGDONG MIDEA KITCHEN APPLIANCES MANUFACTURING CO., LTD.) 23 February 2024 (2024-02-23)<br>claims 1-14 | 1-14 |
| A | CN 116546684 A (GD WITOL VACUUM ELECTRONIC MANUFACTURE CO., LTD.) 04 August 2023 (2023-08-04)<br>description, paragraphs [0054]-[0127], and figures 1-9 | 1-14 |
| A | CN 107248811 A (GUANGDONG MIDEA KITCHEN APPLIANCES MANUFACTURING CO., LTD. et al.) 13 October 2017 (2017-10-13)<br>entire document | 1-14 |
| A | CN 116193660 A (GD WITOL VACUUM ELECTRONIC MANUFACTURE CO., LTD. et al.) 30 May 2023 (2023-05-30)<br>entire document | 1-14 |
| A | JP 2001076861 A (TOSHIBA CORP.) 23 March 2001 (2001-03-23)<br>entire document | 1-14 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **23 September 2024** | **01 October 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2024/107726** |

**C.      DOCUMENTS CONSIDERED TO BE RELEVANT**

| Category* | Citation of document, with indication, where appropriate, of the relevant passages | Relevant to claim No. |
|---|---|---|
| A | JP H0935867 A (MATSUSHITA ELECTRIC INDUSTRIAL CO., LTD.) 07 February 1997 (1997-02-07) entire document | 1-14 |

Form PCT/ISA/210 (second sheet) (July 2022)

**INTERNATIONAL SEARCH REPORT**
**Information on patent family members**

International application No.

**PCT/CN2024/107726**

| Patent document cited in search report | | | Publication date (day/month/year) | Patent family member(s) | Publication date (day/month/year) |
|---|---|---|---|---|---|
| CN | 117590276 | A | 23 February 2024 | None | |
| CN | 116546684 | A | 04 August 2023 | None | |
| CN | 107248811 | A | 13 October 2017 | None | |
| CN | 116193660 | A | 30 May 2023 | None | |
| JP | 2001076861 | A | 23 March 2001 | None | |
| JP | H0935867 | A | 07 February 1997 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311471358